# EUROPEAN PATENT APPLICATION

(11) **EP 4 191 570 A1**
(43) Date of publication of application: **07.06.2023**
(21) Application number: 21850184.9
(22) Date of filing: 12.07.2021
(51) Int. Cl.: G09G 3/32

(54) **LIGHT-EMITTING MODULE AND DISPLAY DEVICE**

(30) Priority: 27.07.2020 CN 202010730608
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Zacco GmbH
(86) International application number: PCT/CN2021/105670
(87) International publication number: WO 2022/022268

(57) **Abstract**

A light emitting module (100), including: a light emitting structure (101), an intermediate substrate (104), an IC (102) and an IC input structure (1022); where, the IC input structure (107) is configured to transmit an IC (102) driving input for driving the IC (102) to the IC (102); a plurality of IC output terminals (1022) included in the IC (102) are configured to transmit light emitting unit (150) driving inputs for driving the light emitting structure (101) to the light emitting structure (101); the intermediate substrate (104) is electrically connected between the light emitting structure (101) and the IC (102), and is configured to transmit light emitting unit (150) driving inputs from the IC (102) to the light emitting structure (101); and the light emitting structure (101) is configured to receive the light emitting unit (150) driving inputs by a plurality of light emitting unit input terminals (110). By the light emitting module (100) provided by the present application, terminals for leading wires from light emitting devices may also be effectively arranged, and the light emitting devices may be accordingly controlled even if a size of the light emitting devices is very small.

## Description

The present application claims priority to the Chinese Patent Application with an application number of 202010730608.5 and a title of "Light Emitting Module and Display Device", filed to China National Intellectual Property Administration on July, 27th, 2020, the disclosures of which are hereby incorporated by reference.

### TECHNICAL FIELD

The present application relates to the technical field of optics, and for example, relates to a light emitting module and a display device.

### BACKGROUND

In the display field, to control a light emitting device (e.g., light emitting unit), a terminal for leading a wire from the light emitting device needs to be provided.

In a process of implementing embodiments of the present disclosure, at least the following problems are found in related technologies:
There is no technical solution to arrange terminals for leading wires from light emitting devices and accordingly control the light emitting devices when a size of the light emitting devices is very small.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a light emitting module and a display device, to solve a technical problem that there is no technical solution to arrange terminals for leading wires from light emitting devices and accordingly control the light emitting devices.

The light emitting module provided by embodiments of the present disclosure includes: a light emitting structure, an intermediate substrate, an Integrated Circuit (IC) and an IC input structure; where,
the IC input structure is configured to transmit an IC driving input for driving the IC to the IC;
the IC includes an IC main body and a plurality of IC output terminals; where,
the plurality of IC output terminals are configured to transmit light emitting unit driving inputs for driving the light emitting structure;
the intermediate substrate is electrically connected between the light emitting structure and the IC, and is configured to transmit light emitting unit driving inputs from the IC to the light emitting structure;
the light emitting structure includes: a light emitting structure electrical connection layer, a light emitting unit layer and a plurality of light emitting unit input terminals; where,
the light emitting unit layer includes a plurality of light emitting units;
the light emitting structure electrical connection layer is formed at the light emitting unit layer through a semiconductor process, and is configured to electrically connect the plurality of light emitting unit input terminals with the plurality of light emitting units; and
the plurality of light emitting unit input terminals are configured to receive the light emitting unit driving inputs.

In some embodiments, an intermediate substrate may include: a substrate electrical connection layer, a plurality of substrate input terminals and a plurality of substrate output terminals; where,
the substrate electrical connection layer is configured to electrically connect the plurality of substrate input terminals with the plurality of substrate output terminals;
the plurality of substrate input terminals are configured to receive light emitting unit driving inputs from an IC; and
the plurality of substrate output terminals are configured to transmit the light emitting unit driving inputs to a plurality of light emitting unit input terminals.

In some embodiments, a plurality of substrate output terminals may be electrically connected with a plurality of light emitting unit input terminals.

In some embodiments, different substrate output terminals of a plurality of substrate output terminals may be electrically connected with different light emitting unit input terminals of a plurality of light emitting unit input terminals, respectively.

In some embodiments, a plurality of substrate output terminals may be arranged opposite to a plurality of light emitting unit input terminals.

In some embodiments, a plurality of substrate output terminals and a plurality of light emitting unit input terminals may be arranged in a package body.

In some embodiments, a plurality of substrate input terminals may be electrically connected with a plurality of substrate output terminals through substrate connecting paths.

In some embodiments, a plurality of IC output terminals may be electrically connected with a plurality of substrate input terminals.

In some embodiments, different IC output terminals of a plurality of IC output terminals may be electrically connected with different substrate input terminals of a plurality of substrate input terminals, respectively.

In some embodiments, a plurality of IC output terminals may be arranged opposite to a plurality of substrate input terminals.

In some embodiments, a plurality of IC output terminals and a plurality of substrate input terminals may be arranged in a package body.

In some embodiments, an IC input structure may include: a plurality of IC input terminals, arranged at an IC main body and configured to transmit IC driving inputs to the IC main body.

In some embodiments, a plurality of IC input terminals may be arranged at one side, away from a light emitting structure, of the IC main body.

In some embodiments, an IC input structure may further include: a plurality of IC input connecting terminals, arranged at an intermediate substrate, electrically connected with a plurality of IC input terminals and configured to transmit IC driving inputs to the IC input terminals.

In some embodiments, different IC input terminals of a plurality of IC input terminals may be electrically connected with different IC input connecting terminals of a plurality of IC input connecting terminals, respectively.

In some embodiments, a plurality of IC input terminals may be arranged opposite to a plurality of IC input connecting terminals.

In some embodiments, a plurality of IC input terminals and a plurality of IC input connecting terminals may be arranged in a package body.

In some embodiments, an IC input structure may further include: a plurality of connector receiving terminals, arranged at an intermediate substrate, electrically connected with a plurality of IC input connecting terminals, and configured to receive IC driving inputs to be transmitted by the plurality of IC input connecting terminals and transmit the IC driving inputs to the plurality of IC input connecting terminals.

In some embodiments, a light emitting module may further include: a connector, electrically connected with a plurality of connector receiving terminals and configured to transmit IC driving inputs to the plurality of connector receiving terminals.

In some embodiments, a plurality of IC input connecting terminals may be electrically connected with a plurality of connector receiving terminals through IC input connecting paths.

In some embodiments, an IC main body may include an IC die.

In some embodiments, an IC die may be arranged in a package body.

In some embodiments, an intermediate substrate may be a Printed Circuit Board (PCB).

In some embodiments, from a light emitting unit layer to a plurality of light emitting unit input terminals, the light emitting unit layer, a light emitting structure electrical connection layer and the plurality of light emitting unit input terminals may be sequentially arranged.

In some embodiments, in part or all of a plurality of light emitting units, a light emitting unit light isolation structure may be arranged between two adjacent light emitting units.

In some embodiments, a light emitting module may further include: a light conversion layer, including a plurality of pixel units.

In some embodiments, a light conversion layer may be arranged at one side, away from a light emitting structure electrical connection layer, of a light emitting unit layer.

In some embodiments, in part or all of a plurality of pixel units, a pixel light isolation structure may be arranged between two adjacent pixel units.

In some embodiments, a light emitting module may further include: a light-transmissive substrate.

In some embodiments, in the case that a light conversion layer is arranged at one side, away from a light emitting structure electrical connection layer, of a light emitting unit layer, a light-transmissive substrate may be arranged at one side, away from the light emitting unit layer, of the light conversion layer.

In some embodiments, a plurality of light emitting units may include at least one Light Emitting Diode (LED).

In some embodiments, at least one LED may include at least one of:
at least one Mini LED;
at least one Micro LED.

In some embodiments, a light emitting structure electrical connection layer may include: a plurality of terminal-side conductive holes and a plurality of light emitting unit-side conductive holes; where,
the light emitting structure electrical connection layer is electrically connected with a plurality of light emitting units through the plurality of light emitting unit-side conductive holes, and is electrically connected with a plurality of light emitting unit input terminals through the plurality of terminal-side conductive holes.

In some embodiments, a light emitting structure electrical connection layer at least may include a light emitting unit-side electrical connection layer and a terminal-side electrical connection layer; a plurality of light emitting unit-side conductive holes may include a plurality of first light emitting unit conductive holes and a plurality of second light emitting unit conductive holes;

where, the light emitting unit-side electrical connection layer may be electrically connected with a plurality of light emitting units through the plurality of first light emitting unit conductive holes;
the terminal-side electrical connection layer may be electrically connected with the plurality of light emitting units through the plurality of second light emitting unit conductive holes.

In some embodiments, at least one of a plurality of light emitting units may include a first electrode and a second electrode;
where, a light emitting unit-side electrical connection layer may be electrically connected with the first electrode through at least one of a plurality of first light emitting unit conductive holes;
a terminal-side electrical connection layer may be electrically connected with the second electrode through at least one of a plurality of second light emitting unit conductive holes.

In some embodiments, a plurality of terminal-side conductive holes may include a plurality of first terminal conductive holes and a plurality of second terminal conductive holes;
where, a light emitting unit-side electrical connection layer may be electrically connected with a plurality of light emitting unit input terminals through the plurality of first terminal conductive holes;
a terminal-side electrical connection layer may be electrically connected with the plurality of light emitting unit input terminals through the plurality of second terminal conductive holes.

In some embodiments, a plurality of light emitting unit input terminals may include at least one first light emitting unit input terminal and at least one second light emitting unit input terminal;
where, a light emitting unit-side electrical connection layer may be electrically connected with at least one first light emitting unit input terminal through at least one of a plurality of first terminal conductive holes;
a terminal-side electrical connection layer may be electrically connected with at least one second light emitting unit input terminal through at least one of a plurality of second terminal conductive holes.

In some embodiments, at least one of a light emitting unit-side electrical connection layer and a terminal-side electrical connection layer may be arranged in the following modes:
the light emitting unit-side electrical connection layer includes at least one layer of light emitting unit-side conductive lines;
the terminal-side electrical connection layer includes at least one layer of terminal-side conductive lines.

In some embodiments, each line of the terminal-side conductive lines may be electrically connected with at least one light emitting unit input terminal of a plurality of light emitting unit input terminals. Optionally, each line of light emitting unit-side conductive lines may be electrically connected with at least one light emitting unit input terminal of a plurality of light emitting unit input terminals.

The display device provided by embodiments of the present disclosure includes the light emitting module.

The light emitting module and the display device provided by embodiments of the present disclosure may achieve the following technical effects:
Terminals for leading wires from light emitting devices may also be effectively arranged, and the light emitting devices may be accordingly controlled even if a size of the light emitting devices is very small.

The above general description and the following description are exemplary and explanatory only, and are not intended to limit the present application.

### BRIEF DESCRIPTION OF DRAWINGS

At least one embodiment is illustrated by the corresponding drawings, and the illustrations and drawings do not limit the embodiments. Elements having the same reference numerals in the drawings are shown as similar elements, and the drawings are not intended to limit the scale, where:
Figs. 1A, 1B and 1C are structural schematic diagrams of a light emitting module provided by embodiments of the present disclosure;
Figs. 2A, 2B and 2C are other structural schematic diagrams of a light emitting module provided by embodiments of the present disclosure;
Fig. 3 is another structural schematic diagram of a light emitting module provided by embodiments of the present disclosure;
Fig. 4 is another structural schematic diagram of a light emitting module provided by embodiments of the present disclosure;
Fig. 5 is a structural schematic diagram of an intermediate substrate provided by embodiments of the present disclosure;
Fig. 6 is another structural schematic diagram of a light emitting module provided by embodiments of the present disclosure;
Figs. 7A and 7B are other structural schematic diagrams of a light emitting module provided by embodiments of the present disclosure;
Figs. 8A and 8B are other structural schematic diagrams of a light emitting module provided by embodiments of the present disclosure;
Fig. 9 is another structural schematic diagram of a light emitting module provided by embodiments of the present disclosure;
Fig. 10 is another structural schematic diagram of a light emitting module provided by embodiments of the present disclosure;
Figs. 11A and 11B are other structural schematic diagrams of an intermediate substrate provided by embodiments of the present disclosure;
Fig. 12 is another structural schematic diagram of an intermediate substrate provided by embodiments of the present disclosure;
Fig. 13 is a structural schematic diagram of an IC input connecting path provided by embodiments of the present disclosure;
Fig. 14 is a structural schematic diagram of an IC provided by embodiments of the present disclosure;
Fig. 15 is another structural schematic diagram of an IC provided by embodiments of the present disclosure;
Fig. 16 is a structural schematic diagram of a light emitting unit layer provided by embodiments of the present disclosure;
Fig. 17 is another structural schematic diagram of a light emitting module provided by embodiments of the present disclosure;
Fig. 18 is a structural schematic diagram of a light conversion layer provided by embodiments of the present disclosure;
Fig. 19 is another structural schematic diagram of a light emitting module provided by embodiments of the present disclosure;
Fig. 20 is a structural schematic diagram of a light emitting structure electrical connection layer provided by embodiments of the present disclosure;
Fig. 21 is another structural schematic diagram of a light emitting structure electrical connection layer provided by embodiments of the present disclosure;
Fig. 22 is another structural schematic diagram of a light emitting structure electrical connection layer provided by embodiments of the present disclosure;
Fig. 23 is another structural schematic diagram of a light emitting structure electrical connection layer provided by embodiments of the present disclosure;
Fig. 24 is another structural schematic diagram of a light emitting structure electrical connection layer provided by embodiments of the present disclosure;
Figs. 25A and 25B are structural schematic diagrams of a light emitting unit-side electrical connection layer and a terminal-side electrical connection layer provided by embodiments of the present disclosure; and
Fig. 26 is a structural schematic diagram of a display device provided by embodiments of the present disclosure.

### Reference numerals:

100: light emitting module; 101: light emitting structure; 102: IC; 1021: IC main body; 1022: IC output terminal; 1023: IC die; 103: light emitting unit layer; 104: intermediate substrate; 107: IC input structure; 1071: IC input connecting terminal; 1073: connector receiving terminal; 1075: IC input terminal; 108: connector; 109: IC input connecting path; 110: light emitting unit input terminal; 111: first light emitting unit input terminal; 112: second light emitting unit input terminal; 115: light emitting unit light isolation structure; 116: package body; 117: light conversion layer; 1171: pixel unit; 118: pixel light isolation structure; 119: light-transmissive substrate; 120: terminal-side conductive hole; 121: first terminal conductive hole; 122: second terminal conductive hole; 124: package body; 125: package body; 126: package body; 130: light emitting structure electrical connection layer; 131: light emitting unit-side electrical connection layer; 1311: light emitting unit-side conductive line; 132: terminal-side electrical connection layer; 1321: terminal-side conductive line; 140: light emitting unit-side conductive hole; 141: first light emitting unit conductive hole; 142: second light emitting unit conductive hole; 150: light emitting unit; 151: first electrode; 152: second electrode; 161: substrate electrical connector layer; 163: substrate input terminal; 165: substrate output terminal; 167: substrate connecting path; and 300: display device.

### DETAILED DESCRIPTION OF EMBODIMENTS

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, at least one embodiment may be implemented without the details. In other cases, to simplify the accompanying drawings, well-known structures and apparatuses may be shown simplistically.

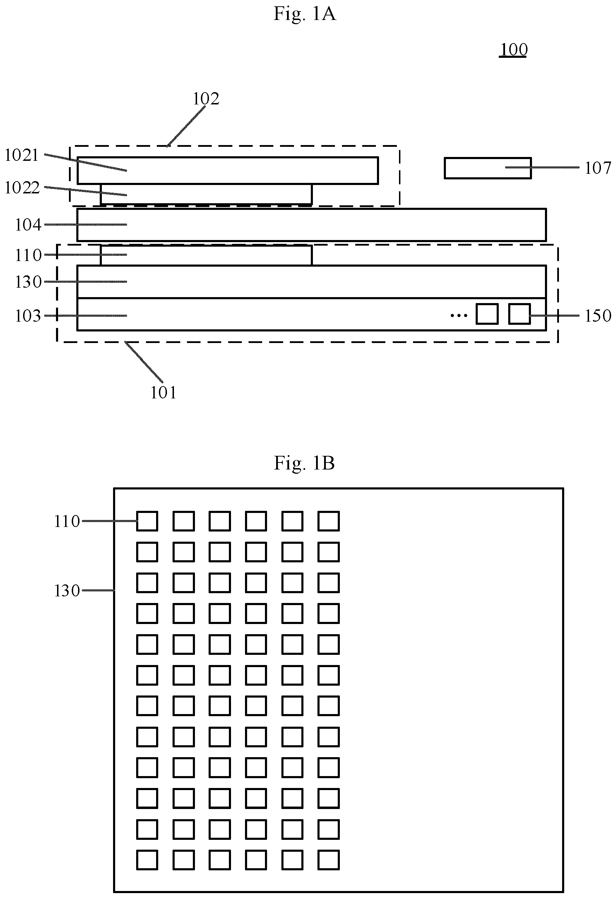

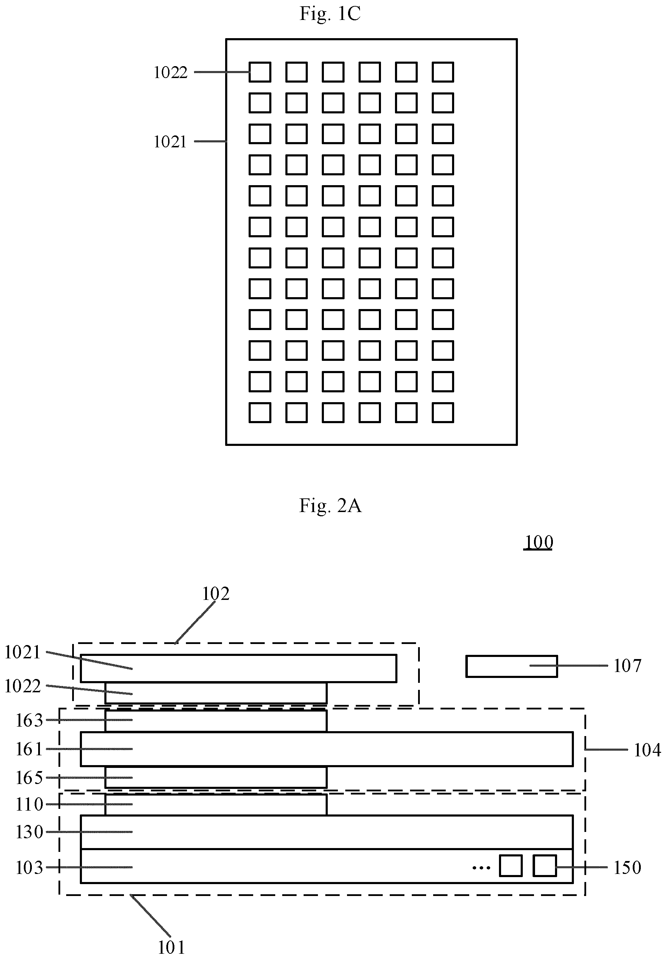

Referring to Figs. 1A, 1B and 1C, embodiments of the present disclosure provide a light emitting module 100, including: a light emitting structure 101, an intermediate substrate 104, an IC 102 and an IC input structure 107; where,
the IC input structure 107 is configured to transmit an IC driving input for driving the IC 102 to the IC 102;
the IC 102 includes: an IC main body 1021 and a plurality of IC output terminals 1022; where,
the plurality of IC output terminals 1022 are configured to transmit light emitting unit driving inputs for driving the light emitting structure 101;
the intermediate substrate 104 is electrically connected between the light emitting structure 101 and the IC 102, and is configured to transmit light emitting unit driving inputs from the IC 102 to the light emitting structure 101;
the light emitting structure 101 includes: a light emitting structure electrical connection layer 130, a light emitting unit layer 103 and a plurality of light emitting unit input terminals 110; where,
the light emitting unit layer 103 includes a plurality of light emitting units 150;
the light emitting structure electrical connection layer 130 is formed at the light emitting unit layer 103 through a semiconductor process, and is configured to electrically connect the plurality of light emitting unit input terminals 110 with the plurality of light emitting units 150;
the plurality of light emitting unit input terminals 110 are configured to receive the light emitting unit driving inputs.

In this way, the plurality of light emitting unit input terminals 110 are capable of transmitting the received light emitting unit driving inputs to the plurality of light emitting units 150 of the light emitting unit layer 103 through the light emitting structure electrical connection layer 130, so as to implement control for the light emitting units 150.

In some embodiments, for brevity and clarity of description, a plurality of light emitting unit input terminals 110 are represented by a rectangular frame with a reference numeral 110 in Fig. 1A (similarly hereinafter). Optionally, a plurality of light emitting unit input terminals 110 may be as shown in Fig. 1B, where each rectangular frame with the reference numeral 110 may represent one light emitting unit input terminal 110 (similarly hereinafter). The number and the arrangement position relationship of the plurality of light emitting unit input terminals 110 shown in Figs. 1A and 1B are exemplary, but not restrictive.

In some embodiments, for brevity and clarity of description, a plurality of IC output terminals 1022 are represented by a rectangular frame with a reference numeral 1022 in Fig. 1A (similarly hereinafter). Optionally, a plurality of IC output terminals 1022 may be as shown in Fig. 1C, where each rectangular frame with the reference numeral 1022 may represent one IC output terminal 1022 (similarly hereinafter). The number and the arrangement position relationship of the plurality of IC output terminals 1022 shown in Figs. 1A and 1C are exemplary, but not restrictive.

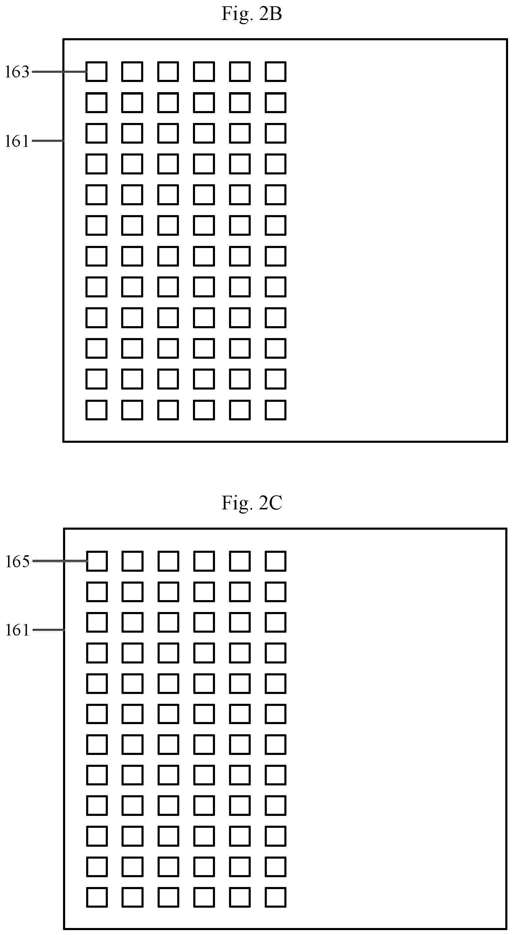

Referring to Figs. 2A, 2B and 2C, in some embodiments, an intermediate substrate 104 may include: a substrate electrical connection layer 161, a plurality of substrate input terminals 163 and a plurality of substrate output terminals 165; where,
the substrate electrical connection layer 161 is configured to electrically connect the plurality of substrate input terminals 163 with the plurality of substrate output terminals 165;
the plurality of substrate input terminals 163 are configured to receive light emitting unit driving inputs from an IC 102;
the plurality of substrate output terminals 165 are configured to transmit the light emitting unit driving inputs to a plurality of light emitting unit input terminals 110.

In some embodiments, for brevity and clarity of description, a plurality of substrate input terminals 163 are represented by a rectangular frame with a reference numeral 163 in Fig. 2A (similarly hereinafter). Optionally, a plurality of substrate input terminals 163 may be as shown in Fig. 2B, where each rectangular frame with the reference numeral 163 may represent one substrate input terminal 163 (similarly hereinafter). The number and the arrangement position relationship of the plurality of substrate input terminals 163 shown in Figs. 2A and 2B are exemplary, but not restrictive.

In some embodiments, for brevity and clarity of description, a plurality of substrate output terminals 165 are represented by a rectangular frame with a reference numeral 165 in Fig. 2A (similarly hereinafter). Optionally, a plurality of substrate output terminals 165 may be as shown in Fig. 2C, where each rectangular frame with the reference numeral 165 may represent one substrate output terminal 165 (similarly hereinafter). The number and the arrangement position relationship of the plurality of substrate output terminals 165 shown in Figs. 2A and 2C are exemplary, but not restrictive.

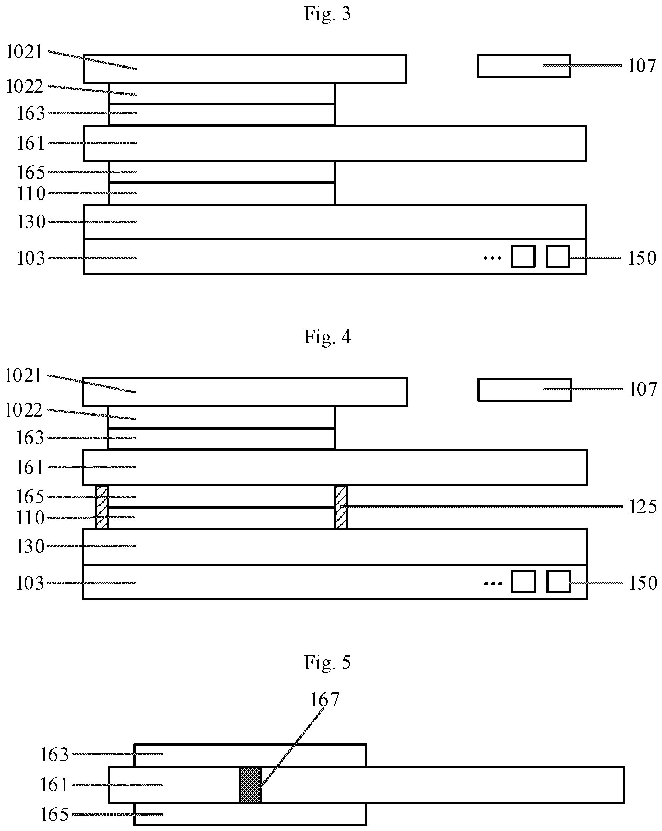

Referring to Fig. 3, in some embodiments, a plurality of substrate output terminals 165 may be electrically connected with a plurality of light emitting unit input terminals 110.

In some embodiments, different substrate output terminals 165 of a plurality of substrate output terminals 165 may be electrically connected with different light emitting unit input terminals 110 of a plurality of light emitting unit input terminals 110, respectively.

In some embodiments, a plurality of substrate output terminals 165 may be arranged opposite to a plurality of light emitting unit input terminals 110.

In some embodiments, the arrangement position relationship between a plurality of substrate output terminals 165 and a plurality of light emitting unit input terminals 110 may also be considered according to actual conditions such as process requirements, as long as the plurality of substrate output terminals 165 and the plurality of light emitting unit input terminals 110 are capable of being connected effectively and electrically and operating normally.

In some embodiments, part or all of a plurality of substrate output terminals 165 and a plurality of light emitting unit input terminals 110 may be arranged in array.

In some embodiments, whether part or all of a plurality of substrate output terminals 165 and a plurality of light emitting unit input terminals 110 are arranged in array, an array arrangement mode may be a matrix, such as a row-and-column mode. In some embodiments, an array arrangement mode may be different from the row-and-column mode, but may be arrangement modes in other array shapes, such as circular, elliptical, triangular and other array arrangement modes.

In some embodiments, shapes of part or all of a plurality of substrate output terminals 165 and a plurality of light emitting unit input terminals 110 may be the same or different. Optionally, shapes of the plurality of substrate output terminals 165 and the plurality of light emitting unit input terminals 110 may refer to shapes of longitudinal projections of the plurality of substrate output terminals 165 and the plurality of light emitting unit input terminals 110. Optionally, the shape of at least one of the plurality of substrate output terminals 165 and the plurality of light emitting unit input terminals 110 may be rectangular, circular, spherical or other shapes, and may also be set to polygonal, irregular or other shapes according to actual conditions such as process requirements.

In some embodiments, array arrangement modes and shapes of a plurality of substrate output terminals 165 and a plurality of light emitting unit input terminals 110 are insignificant, as long as the plurality of substrate output terminals 165 and the plurality of light emitting unit input terminals 110 are capable of being connected effectively and electrically and operating normally.

Referring to Fig. 4, in some embodiments, a plurality of substrate output terminals 165 and a plurality of light emitting unit input terminals 110 may be arranged in a package body 125.

A shape and an arrangement position relationship of the package body 125 shown in Fig. 4 are exemplary, but not restrictive. The shape and the arrangement position relationship of the package body 125 are insignificant, as long as the package body 125 is capable of effectively packaging substrate output terminals 165 and light emitting unit input terminals 110, so that the plurality of substrate output terminals 165 and the plurality of light emitting unit input terminals 110 are capable of being connected effectively and electrically and operating normally.

Referring to Fig. 5, in some embodiments, a plurality of substrate input terminals 163 may be electrically connected with a plurality of substrate output terminals 165 through substrate connecting paths 167.

The shape and the arrangement position relationship of the substrate input connecting paths 167 shown in Fig. 5 are exemplary, but not restrictive.

In some embodiments, different substrate input terminals 163 of a plurality of substrate input terminals 163 may be electrically connected with different substrate output terminals 165 of a plurality of substrate output terminals 165 respectively through substrate connecting paths 167.

In some embodiments, substrate connecting paths 167 may include a plurality of substrate connecting lines; and different substrate input terminals 163 of a plurality of substrate input terminals 163 may be electrically connected with different substrate output terminals 165 of a plurality of substrate output terminals 165 respectively through different substrate connecting lines.

In some embodiments, a plurality of IC output terminals 1022 may be electrically connected with a plurality of substrate input terminals 163.

In some embodiments, different IC output terminals 1022 of a plurality of IC output terminals 1022 may be electrically connected with different substrate input terminals 163 of a plurality of substrate input terminals 163, respectively.

In some embodiments, a plurality of IC output terminals 1022 may be arranged opposite to a plurality of substrate input terminals 163.

In some embodiments, the arrangement position relationship between a plurality of IC output terminals 1022 and a plurality of substrate input terminals 163 may also be considered according to actual conditions such as process requirements, as long as the plurality of IC output terminals 1022 and the plurality of substrate input terminals 163 are capable of being connected effectively and electrically and operating normally.

In some embodiments, part or all of a plurality of IC output terminals 1022 and a plurality of substrate input terminals 163 may be arranged in array.

In some embodiments, whether part or all of a plurality of IC output terminals 1022 and a plurality of substrate input terminals 163 are arranged in array, an array arrangement mode may be a matrix, such as a row-and-column mode. In some embodiments, an array arrangement mode may be different from the row-and-column mode, but may be arrangement modes in other array shapes, such as circular, elliptical, triangular and other array arrangement modes.

In some embodiments, shapes of part or all of a plurality of IC output terminals 1022 and a plurality of substrate input terminals 163 may be the same or different. Optionally, shapes of the plurality of IC output terminals 1022 and the plurality of substrate input terminals 163 may refer to shapes of longitudinal projections of the plurality of IC output terminals 1022 and the plurality of substrate input terminals 163. Optionally, the shape of at least one of the plurality of IC output terminals 1022 and the plurality of substrate input terminals 163 may be rectangular, circular, spherical or other shapes, and may also be set to polygonal, irregular or other shapes according to actual conditions such as process requirements.

In some embodiments, array arrangement modes and shapes of a plurality of IC output terminals 1022 and a plurality of substrate input terminals 163 are insignificant, as long as the plurality of IC output terminals 1022 and the plurality of substrate input terminals 163 are capable of being connected effectively and electrically and operating normally.

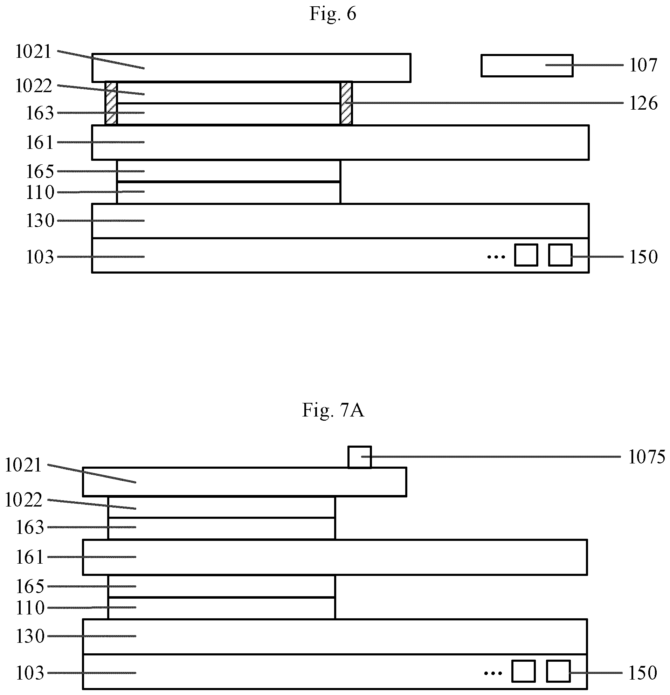

Referring to Fig. 6, in some embodiments, a plurality of IC output terminals 1022 and a plurality of substrate input terminals 163 may be arranged in a package body 126.

A shape and an arrangement position relationship of the package body 126 shown in Fig. 6 are exemplary, but not restrictive. The shape and the arrangement position relationship of the package body 126 are insignificant, as long as the package body 126 is capable of effectively packaging IC output terminals 1022 and substrate input terminals 163, so that the plurality of IC output terminals 1022 and the plurality of substrate input terminals 163 are capable of being connected effectively and electrically and operating normally.

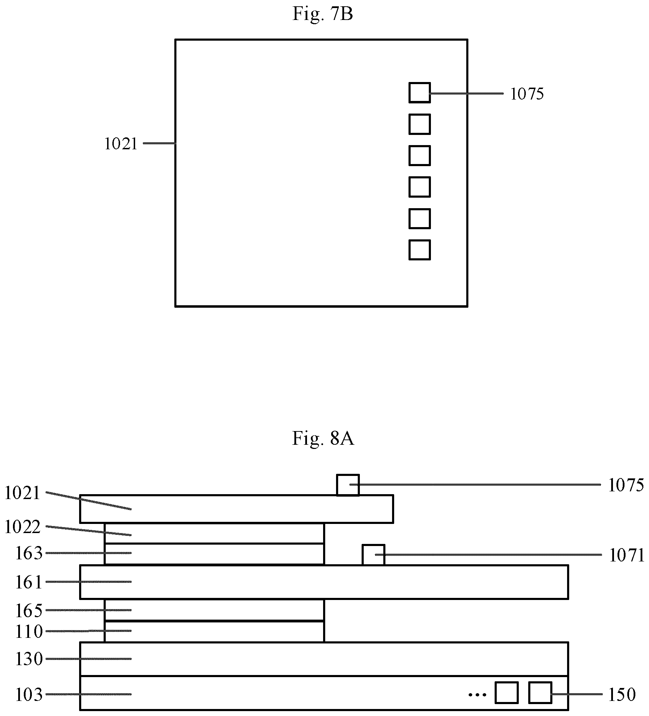

Referring to Figs. 7A and 7B, in some embodiments, an IC input structure 107 may include: a plurality of IC input terminals 1075, arranged at an IC main body 1021 and configured to transmit IC driving inputs to the IC main body 1021.

In some embodiments, for brevity and clarity of description, a plurality of IC input terminals 1075 are represented by a rectangular frame with a reference numeral 1075 in Fig. 7A (similarly hereinafter). Optionally, a plurality of IC input terminals 1075 may be as shown in Fig. 7B, where each rectangular frame with the reference numeral 1075 may represent one IC input terminal 1075 (similarly hereinafter). The number and the arrangement position relationship of the plurality of IC input terminals 1075 shown in Figs. 7A and 7B are exemplary, but not restrictive.

In some embodiments, a plurality of IC input terminals 1075 may be arranged at one side, away from a light emitting structure 101, of the IC main body 1021. The arrangement position relationship of the plurality of IC input terminals 1075 is insignificant, as long as the plurality of IC input terminals 1075 is capable of transmitting IC driving inputs to the IC main body 1021.

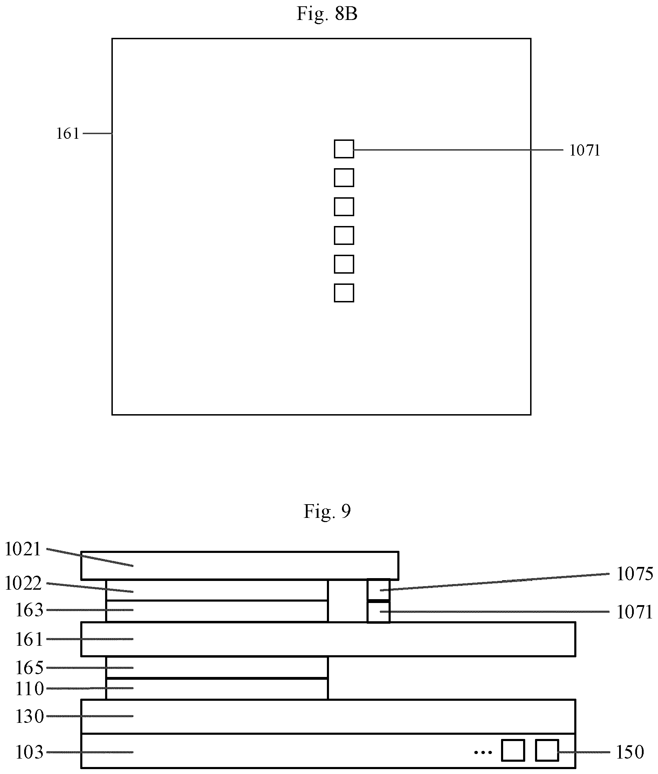

Referring to Figs. 8A and 8B, in some embodiments, an IC input structure 107 may further include: a plurality of IC input connecting terminals 1071, arranged at an intermediate substrate 104, electrically connected with a plurality of IC input terminals 1075 and configured to transmit IC driving inputs to the IC input terminals 1075.

In some embodiments, for brevity and clarity of description, a plurality of IC input connecting terminals 1071 are represented by a rectangular frame with a reference numeral 1071 in Fig. 8A (similarly hereinafter). Optionally, a plurality of IC input connecting terminals 1071 may be as shown in Fig. 8B, where each rectangular frame with the reference numeral 1071 may represent one IC input connecting terminal 1071 (similarly hereinafter). The number and the arrangement position relationship of the plurality of IC input connecting terminals 1071 shown in Figs. 8A and 8B are exemplary, but not restrictive.

In some embodiments, different IC input terminals 1075 of a plurality of IC input terminals 1075 may be electrically connected with different IC input connecting terminals 1071 of a plurality of IC input connecting terminals 1071, respectively.

Referring to Fig. 9, in some embodiments, a plurality of IC input terminals 1075 may be arranged opposite to a plurality of IC input connecting terminals 1071.

The arrangement position relationship of the IC input terminals 1075 and the IC input connecting terminals 1071 shown in Fig. 9 is exemplary, but not restrictive. The arrangement position relationship of the IC input terminals 1075 and the IC input connecting terminals 1071 is insignificant, as long as the plurality of IC input terminals 1075 and the plurality of IC input connecting terminals 1071 are capable of being connected effectively and electrically and operating normally.

In some embodiments, part or all of a plurality of IC input terminals 1075 and a plurality of IC input connecting terminals 1071 may be arranged in array.

In some embodiments, whether part or all of a plurality of IC input terminals 1075 and a plurality of IC input connecting terminals 1071 are arranged in array, an array arrangement mode may be a matrix, such as a row-and-column mode. In some embodiments, an array arrangement mode may be different from the row-and-column mode, but may be arrangement modes in other array shapes, such as circular, elliptical, triangular and other array arrangement modes.

In some embodiments, shapes of part or all of a plurality of IC input terminals 1075 and a plurality of IC input connecting terminals 1071 may be the same or different. Optionally, shapes of the plurality of IC input terminals 1075 and the plurality of IC input connecting terminals 1071 may refer to shapes of longitudinal projections of the plurality of IC input terminals 1075 and the plurality of IC input connecting terminals 1071. Optionally, the shape of at least one of the plurality of IC input terminals 1075 and the plurality of IC input connecting terminals 1071 may be rectangular, circular, spherical or other shapes, and may also be set to polygonal, irregular or other shapes according to actual conditions such as process requirements.

In some embodiments, array arrangement modes and shapes of a plurality of IC input terminals 1075 and a plurality of IC input connecting terminals 1071 are insignificant, as long as the plurality of IC input terminals 1075 and the plurality of IC input connecting terminals 1071 are capable of being connected effectively and electrically and operating normally.

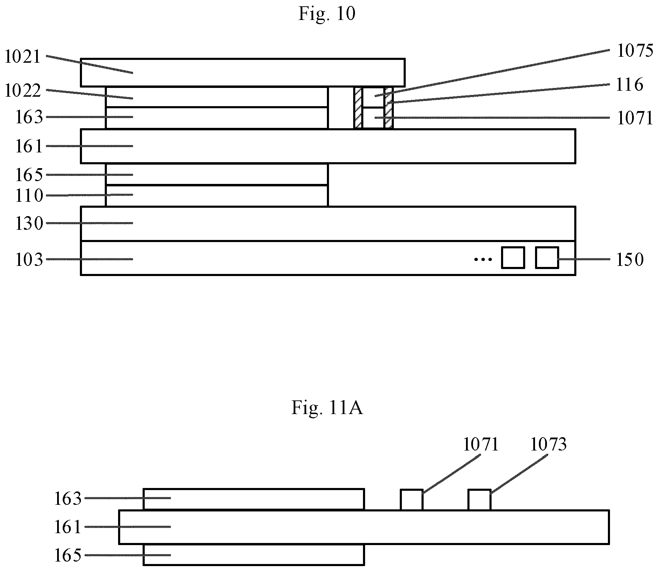

Referring to Fig. 10, in some embodiments, a plurality of IC input terminals 1075 and a plurality of IC input connecting terminals 1071 may be arranged in a package body 116.

The shape and the arrangement position relationship of the package body 116 shown in Fig. 10 are exemplary, but not restrictive. The shape and the arrangement position relationship of the package body 116 are insignificant, as long as the package body 116 is capable of effectively packaging IC input terminals 1075 and IC input connecting terminals 1071, so that the plurality of IC input terminals 1075 and the plurality of IC input connecting terminals 1071 are capable of being connected effectively and electrically and operating normally.

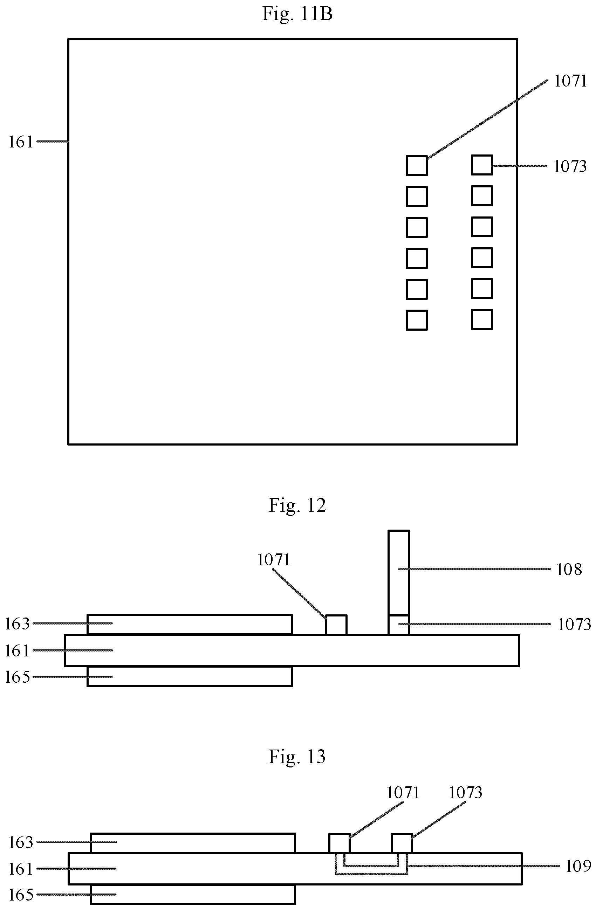

Referring to Figs. 11A and 11B, in some embodiments, an IC input structure 107 may further include: a plurality of connector receiving terminals 1073, arranged at an intermediate substrate 104, electrically connected with a plurality of IC input connecting terminals 1071, and configured to receive IC driving inputs to be transmitted by the plurality of IC input connecting terminals 1071 and transmit the IC driving inputs to the plurality of IC input connecting terminals 1071.

In some embodiments, for brevity and clarity of description, a plurality of connector receiving terminals 1073 are represented by a rectangular frame with a reference numeral 1073 in Fig. 11A (similarly hereinafter). Optionally, a plurality of connector receiving terminals 1073 may be as shown in Fig. 11B, where each rectangular frame with the reference numeral 1073 may represent one connector receiving terminal 1073 (similarly hereinafter). The number and the arrangement position relationship of the plurality of connector receiving terminals 1073 shown in Figs. 11A and 11B are exemplary, but not restrictive.

In some embodiments, a plurality of connector receiving terminals 1073 are capable of being electrically connected with a connector 108 to receive IC driving inputs through the connector 108.

Referring to Fig. 12, in some embodiments, a light emitting module may further include: a connector 108, electrically connected with a plurality of connector receiving terminals 1073 and configured to transmit IC driving inputs to the plurality of connector receiving terminals 1073.

In some embodiments, a connector 108 may include a plug or the like, may include at least one of a male connector and a female connector, and may lead IC driving inputs into connector receiving terminals 1073. Optionally, the connector 108 may be a rigid part or a flexible part, such as a Flexible Printed Circuit Board (FPC).

In some embodiments, a connector 108 may include: a plurality of connector output terminals, electrically connected with a plurality of connector receiving terminals 1073 and configured to transmit IC driving inputs to the plurality of connector receiving terminals 1073.

In some embodiments, connector output terminals and connector receiving terminals 1073 may be represented in the form of male connector and female connector; for example, the connector output terminals are male connectors, and the connector receiving terminals 1073 are female connectors; or, the connector output terminals are female connectors, and the connector receiving terminals 1073 are male connectors.

In some embodiments, different connector output terminals of a plurality of connector output terminals may be electrically connected with different connector receiving terminals 1073 of a plurality of connector receiving terminals 1073, respectively.

In some embodiments, part or all of a plurality of connector output terminals and a plurality of connector receiving terminals 1073 may be arranged in array.

In some embodiments, whether part or all of a plurality of connector output terminals and a plurality of connector receiving terminals 1073 are arranged in array, an array arrangement mode may be a matrix, such as a row-and-column mode. In some embodiments, an array arrangement mode may be different from the row-and-column mode, but may be arrangement modes in other array shapes, such as circular, elliptical, triangular and other array arrangement modes.

In some embodiments, shapes of part or all of a plurality of connector output terminals and a plurality of connector receiving terminals 1073 may be the same or different. Optionally, shapes of the plurality of connector output terminals and the plurality of connector receiving terminals 1073 may refer to shapes of longitudinal projections of the plurality of connector output terminals and the plurality of connector receiving terminals 1073. Optionally, the shape of at least one of the a plurality of connector output terminals and the plurality of connector receiving terminals 1073 may be rectangular, circular, spherical or other shapes, and may also be set to polygonal, irregular or other shapes according to actual conditions such as process requirements.

In some embodiments, array arrangement modes and shapes of a plurality of connector output terminals and a plurality of connector receiving terminals 1073 are insignificant, as long as the plurality of connector output terminals and the plurality of connector receiving terminals 1073 are capable of being connected effectively and electrically and operating normally.

In some embodiments, a plurality of connector output terminals and a plurality of connector receiving terminals 1073 may be arranged in a package body. The shape and the arrangement position relationship of the package body are insignificant, as long as the package body is capable of effectively packaging connector output terminals and connector receiving terminals 1073, so that the plurality of connector output terminals and the plurality of connector receiving terminals 1073 are capable of being connected effectively and electrically and operating normally.

Referring to Fig. 13, in some embodiments, a plurality of IC input connecting terminals 1071 may be electrically connected with a plurality of connector receiving terminals 1073 through IC input connecting paths 109.

The shape and the arrangement position relationship of the IC input connecting paths 109 shown in Fig. 13 are exemplary, but not restrictive.

In some embodiments, different connector receiving terminals 1073 of a plurality of connector receiving terminals 1073 may be electrically connected with different IC input connecting terminals 1071 of a plurality of IC input connecting terminals 1071 respectively through IC input connecting paths 109.

In some embodiments, IC input connecting paths 109 may include a plurality of IC input connecting lines, and different connector receiving terminals 1073 of a plurality of connector receiving terminals 1073 are electrically connected with different IC input connecting terminals 1071 of a plurality of IC input connecting terminals 1071 through different IC input connecting lines.

In some embodiments, IC input connecting paths 109 may be configured to:
directly transmit IC driving inputs received by a plurality of connector receiving terminals 1073 to a plurality of IC input connecting terminals 1071; or
process IC driving inputs received by a plurality of connector receiving terminals 1073 and transmit the processed IC driving inputs to a plurality of IC input connecting terminals 1071.

In some embodiments, IC input connecting paths 109 may be arranged at an intermediate substrate 104.

In some embodiments, part or all of IC input connecting paths 109 may be arranged inside or outside an intermediate substrate 104. The arrangement position and the shape are insignificant, as long as the IC input connecting paths 109 are capable of operating normally.

In some embodiments, IC input connecting paths 109 may be arranged at a surface of an intermediate substrate 104.

In some embodiments, IC input connecting paths 109 may be arranged in a package body. The shape and the arrangement position relationship of the IC input connecting paths 109 and the package body are insignificant, as long as the package body is capable of effectively packaging the IC input connecting paths 109 to make the IC input connecting paths 109 operate normally.

In some embodiments, besides the above arrangement position relationships, other arrangement positions of an IC input structure 107 may further be considered according to actual conditions such as process requirements, for example, the IC input structure 107 may be partially or wholly arranged at a light emitting structure electrical connection layer 130. Optionally, the arrangement position relationship between the IC input structure 107 and light emitting unit input terminals 110 may also be considered according to actual conditions such as process requirements, for example, the IC input structure 107 and a plurality of light emitting unit input terminals 110 may be arranged at the same side or different sides of the light emitting structure electrical connection layer 130. Optionally, the IC input structure 107 may also be partially or wholly arranged at other positions than the intermediate substrate 104 and the light emitting structure electrical connection layer 130 according to actual conditions such as process requirements. The arrangement position of the IC input structure 107 is insignificant, as long as a light emitting module 100 is capable of operating normally.

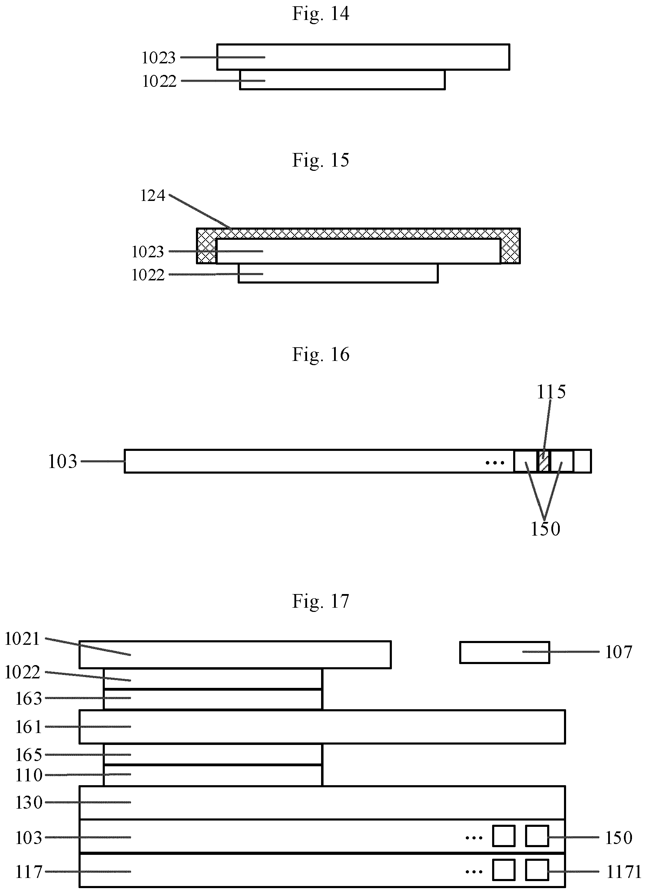

Referring to Fig. 14, in some embodiments, an IC main body 1021 may include an IC die 1023.

Referring to Fig. 15, in some embodiments, an IC die 1023 may be arranged in a package body 124.

A shape and an arrangement position relationship of the package body 124 shown in Fig. 15 are exemplary, but not restrictive. The shape and the arrangement position relationship of the package body 124 are insignificant, as long as the package body 124 is capable of effectively packaging the IC die 1023 to make the IC die 1023 operate normally.

In some embodiments, an intermediate substrate 104 may be a PCB.

In some embodiments, the intermediate substrate 104 may further be provided with a heat dissipation structure, for example, the heat dissipation structure is arranged at a surface of the intermediate substrate 104. Optionally, the heat dissipation structure may include a graphene heat dissipation film, a polycrystalline heat dissipation substrate or the like. Optionally, the polycrystalline heat dissipation substrate may include at least one of aluminum nitride, silicon carbide, diamond and other materials. Optionally, the heat dissipation structure may have sheet, honeycomb and other shapes; and a heat dissipation area of the heat dissipation structure may further be considered according to actual conditions such as process requirements.

In some embodiments, from a light emitting unit layer 103 to a plurality of light emitting unit input terminals 110, the light emitting unit layer 103, a light emitting structure electrical connection layer 130 and the plurality of light emitting unit input terminals 110 may be sequentially arranged.

In some embodiments, an arrangement order of a light emitting unit layer 103, a light emitting structure electrical connection layer 130 and light emitting unit input terminals 110 may also be considered according to actual conditions such as process requirements, as long as a light emitting module 100 is capable of operating normally.

Referring to Fig. 16, in some embodiments, in part or all of a plurality of light emitting units 150, a light emitting unit light isolation structure 115 may be arranged between two adjacent light emitting units 150 to prevent light emitted by the two adjacent light emitting units 150 from being conducted in an undesired direction as much as possible (e.g., the light emitted by the two adjacent light emitting units 150 is conducted to each other).

Referring to Fig. 17, in some embodiments, a light emitting module may further include: a light conversion layer 117, including a plurality of pixel units 1171. Optionally, the light conversion layer 117 may implement color conversion of light in a way of wavelength selection or the like, for example, performing color conversion for light from a light emitting unit layer 103.

In some embodiments, a light conversion layer 117 may be arranged at one side, away from a light emitting structure electrical connection layer 130, of a light emitting unit layer 103.

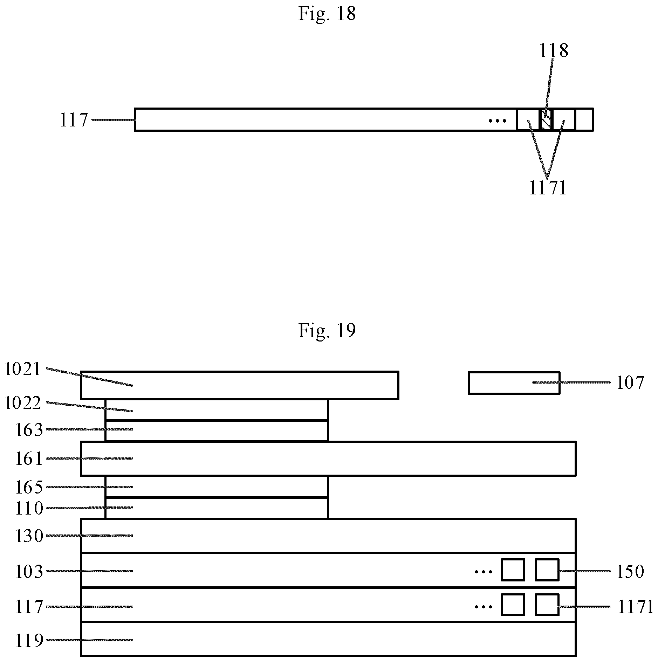

Referring to Fig. 18, in some embodiments, in part or all of a plurality of pixel units 1171, a pixel light isolation structure 118 may be arranged between two adjacent pixel units 1171 to prevent light emitted by two adjacent pixel units 1171 from being conducted in an undesired direction as much as possible (e.g., light emitted by two adjacent pixel units 1171 is conducted to each other).

Referring to Fig. 19, in some embodiments, the light emitting module may further include: a light-transmissive substrate 119.

In some embodiments, in the case that a light conversion layer 117 is arranged at one side, away from a light emitting structure electrical connection layer 130, of a light emitting unit layer 103, a light-transmissive substrate 119 may be arranged at one side, away from the light emitting unit layer 103, of the light conversion layer 117.

In some embodiments, a light-transmissive substrate 119 may be a sapphire substrate, a glass substrate or a touch screen.

In some embodiments, a light-transmissive substrate 119 may be a rigid substrate or a flexible substrate.

In some embodiments, a plurality of light emitting units 150 may include at least one LED, for example, part or all of the plurality of light emitting units 150 may be LEDs.

In some embodiments, at least one LED may include at least one of:
at least one Mini LED;
at least one Micro LED.

In some embodiments, part or all of a plurality of light emitting units 150 may be Mini LEDs or Micro LEDs.

In some embodiments, part or all of a plurality of light emitting units 150 may be arranged in array.

In some embodiments, whether part or all of a plurality of light emitting units 150 are arranged in array, an array arrangement mode of the plurality of light emitting units 150 may be a matrix, such as a row-and-column mode. In some embodiments, an array arrangement mode of a plurality of light emitting units 150 may be different from the row-and-column mode, but may be arrangement modes in other array shapes, such as circular, elliptical, triangular and other array arrangement modes. Optionally, the array arrangement mode of the plurality of light emitting units 150 is insignificant, as long as a plurality of light emitting unit input terminals 110 for leading wires from the light emitting units 150 are capable of being effectively arranged.

In some embodiments, shapes of part or all of light emitting units 150 in a plurality of light emitting units 150 may be the same or different. Optionally, since thicknesses of the light emitting units 150 are usually very small, the shapes of the light emitting units 150 may refer to shapes of longitudinal projections of the light emitting units 150. Optionally, the shape of at least one light emitting unit 150 of the plurality of light emitting units 150 may be rectangular, circular, spherical or other shapes, and may also be set to polygonal, irregular or other shapes according to actual conditions such as process requirements.

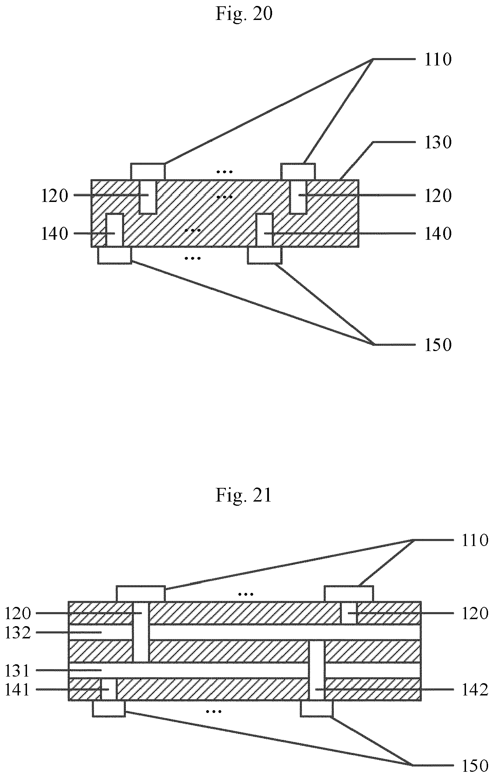

Referring to Fig. 20, in some embodiments, a light emitting structure electrical connection layer 130 may include: a plurality of terminal-side conductive holes 120 and a plurality of light emitting unit-side conductive holes 140; where,
the light emitting structure electrical connection layer 130 is electrically connected with a plurality of light emitting units 150 through the plurality of light emitting unit-side conductive holes 140, and is electrically connected with a plurality of light emitting unit input terminals 110 through the plurality of terminal-side conductive holes 120.

In some embodiments, a light emitting structure electrical connection layer 130 may include at least two light emitting structure electrical connection layers 130; the at least two light emitting structure electrical connection layers 130 are electrically connected with a plurality of light emitting units 150 through a plurality of light emitting unit-side conductive holes 140, and are electrically connected with a plurality of light emitting unit input terminals 110 through a plurality of terminal-side conductive holes 120.

Referring to Fig. 21, in some embodiments, the light emitting structure electrical connection layers 130 may at least include a light emitting unit-side electrical connection layer 131 and a terminal-side electrical connection layer 132; a plurality of light emitting unit-side conductive holes 140 include a plurality of first light emitting unit conductive holes 141 and a plurality of second light emitting unit conductive holes 142;
where, the light emitting unit-side electrical connection layer 131 may be electrically connected with a plurality of light emitting units 150 through the plurality of first light emitting unit conductive holes 141;
the terminal-side electrical connection layer 132 may be electrically connected with the plurality of light emitting units 150 through the plurality of second light emitting unit conductive holes 142.

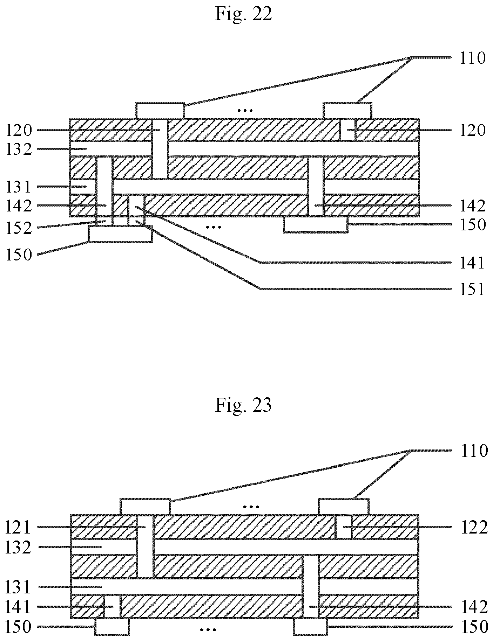

Referring to Fig. 22, in some embodiments, at least one of a plurality of light emitting units 150 may include a first electrode 151 and a second electrode 152;
where, a light emitting unit-side electrical connection layer 131 may be electrically connected with the first electrode 151 through at least one of a plurality of first light emitting unit conductive holes 141;
a terminal-side electrical connection layer 132 may be electrically connected with the second electrode 152 through at least one of a plurality of second light emitting unit conductive holes 142.

In some embodiments, each light emitting unit 150 of a plurality of light emitting units 150 may include a first electrode 151 and a second electrode 152;
where, a light emitting unit-side electrical connection layer 131 may be electrically connected with first electrodes 151 of different light emitting units 150 of the plurality of light emitting units 150 respectively through a plurality of first light emitting unit conductive holes 141;
a terminal-side electrical connection layer 132 may be electrically connected with second electrodes 152 of different light emitting units 150 of the plurality of light emitting units 150 respectively through a plurality of second light emitting unit conductive holes 142.

In some embodiments, from a plurality of light emitting unit input terminals 110 to a light emitting unit layer 103, the plurality of light emitting unit input terminals 110, a terminal-side electrical connection layer 132, a light emitting unit-side electrical connection layer 131 and the light emitting unit layer 103 may be sequentially arranged.

In some embodiments, an arrangement order of light emitting unit input terminals 110, a terminal-side electrical connection layer 132, a light emitting unit-side electrical connection layer 131 and a light emitting unit layer 103 may also be considered according to actual conditions such as process requirements, as long as a light emitting module 100 is capable of operating normally.

In some embodiments, at least one of the following insulation layers may further be included:
an insulation layer for isolating a plurality of light emitting unit input terminals 110 from a terminal-side electrical connection layer 132;
an insulation layer for isolating the terminal-side electrical connection layer 132 from a light emitting unit-side electrical connection layer 131;
an insulation layer for isolating the light emitting unit-side electrical connection layer 131 from a light emitting unit layer 103.

In some embodiments, any one of the above insulation layers may include at least one layer of insulation structure.

Referring to Fig. 23, in some embodiments, the plurality of terminal-side conductive holes 120 may include a plurality of first terminal conductive holes 121 and a plurality of second terminal conductive holes 122;
where, a light emitting unit-side electrical connection layer 131 may be electrically connected with a plurality of light emitting unit input terminals 110 through the plurality of first terminal conductive holes 121;
a terminal-side electrical connection layer 132 may be electrically connected with the plurality of light emitting unit input terminals 110 through the plurality of second terminal conductive holes 122.

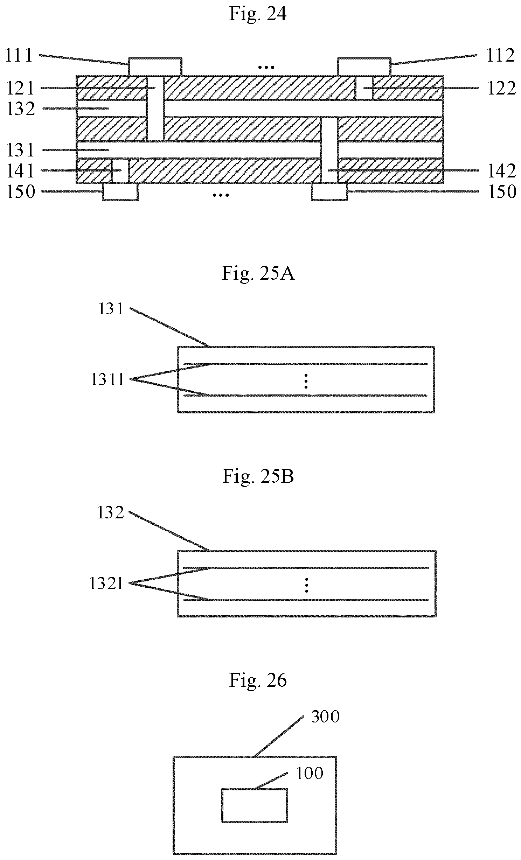

Referring to Fig. 24, in some embodiments, a plurality of light emitting unit input terminals 110 may include at least one first light emitting unit input terminal 111 and at least one second light emitting unit input terminal 112;
where, a light emitting unit-side electrical connection layer 131 may be electrically connected with at least one first light emitting unit input terminal 111 through at least one of a plurality of first terminal conductive holes 121;
a terminal-side electrical connection layer 132 may be electrically connected with at least one second light emitting unit input terminal 112 through at least one of a plurality of second terminal conductive holes 122.

In some embodiments, at least one first light emitting unit input terminal 111 may include a plurality of first light emitting unit input terminals 111, and at least one second light emitting unit input terminal 112 includes a plurality of second light emitting unit input terminals 112;
where, a light emitting unit-side electrical connection layer 131 may be electrically connected with the plurality of first light emitting unit input terminals 111 respectively through a plurality of first terminal conductive holes 121;
a terminal-side electrical connection layer 132 may be electrically connected with the plurality of second light emitting unit input terminals 112 respectively through a plurality of second terminal conductive holes 122.

Referring to Figs. 25A and 25B, in some embodiments, at least one of a light emitting unit-side electrical connection layer 131 and a terminal-side electrical connection layer 132 may be arranged in the following modes:
the light emitting unit-side electrical connection layer 131 includes at least one layer of light emitting unit-side conductive lines 1311;
the terminal-side electrical connection layer 132 includes at least one layer of terminal-side conductive lines 1321.

Referring to Fig. 25A, in some embodiments, the light emitting unit-side electrical connection layer 131 may include at least one layer of light emitting unit-side conductive lines 1311.

Referring to Fig. 25B, in some embodiments, the terminal-side electrical connection layer 132 may include at least one layer of terminal-side conductive lines 1321.

Referring to Figs. 25A and 25B, in some embodiments, at least one of the light emitting unit-side conductive lines 1311 and the terminal-side conductive lines 1321 may be arranged in array. Optionally, at least one of the light emitting unit-side conductive lines 1311 and the terminal-side conductive lines 1321 may be arranged in array in the form of rows or columns.

In some embodiments, light emitting unit-side conductive lines 1311 may be arranged in array in the form of rows, and terminal-side conductive lines 1321 may be arranged in array in the form of columns. Optionally, the light emitting unit-side conductive lines 1311 may be arranged in array in the form of columns, and the terminal-side conductive lines 1321 may be arranged in array in the form of rows.

In some embodiments, besides the above row-and-column mode as the array arrangement mode, an array arrangement mode of light emitting unit-side conductive lines 1311 and terminal-side conductive lines 1321 may be arrangement modes in other array shapes, such as circular, elliptical, triangular and other array arrangement modes. Optionally, the array arrangement mode of the light emitting unit-side conductive lines 1311 and the terminal-side conductive lines 1321 is insignificant, as long as a plurality of light emitting unit input terminals 110 for leading wires from light emitting units 150 are capable of being effectively arranged.

In some embodiments, each line of terminal-side conductive lines 1321 may be electrically connected with at least one light emitting unit input terminal 110 of a plurality of light emitting unit input terminals 110. Optionally, each line of light emitting unit-side conductive lines 1311 may be electrically connected with at least one light emitting unit input terminal 110 of a plurality of light emitting unit input terminals 110.

In some embodiments, each line of terminal-side conductive lines 1321 may be electrically connected with one second light emitting unit input terminal 112 of a plurality of second light emitting unit input terminals 112, so that different lines of the terminal-side conductive lines 1321 are electrically connected with different second light emitting unit input terminals 112 of the plurality of second light emitting unit input terminals 112, respectively. Optionally, each line of the terminal-side conductive lines 1321 may be electrically connected with at least two second light emitting unit input terminals 112 of the plurality of second light emitting unit input terminals 112, to provide a backup of electrical connection between the second light emitting unit input terminals 112 and the terminal-side conductive lines 1321.

In some embodiments, each line of light emitting unit-side conductive lines 1311 may be electrically connected with one first light emitting unit input terminal 111 of a plurality of first light emitting unit input terminals 111, so that different lines of the light emitting unit-side conductive lines 1311 are electrically connected with different first light emitting unit input terminals 111 of the plurality of first light emitting unit input terminals 111, respectively. Optionally, each line of the light emitting unit-side conductive lines 1311 may be electrically connected with at least two first light emitting unit input terminals 111 of the plurality of first light emitting unit input terminals 111, to provide a backup of electrical connection between the first light emitting unit input terminals 111 and the light emitting unit-side conductive lines 1311.

In some embodiments, at least one light emitting unit input terminal 110 of a plurality of light emitting unit input terminals 110 may cover at least one terminal-side conductive hole 120 of a plurality of terminal-side conductive holes 120, for example, at least one light emitting unit input terminal 110 of the plurality of light emitting unit input terminals 110 may cover at least one terminal-side conductive hole 120, which is electrically connected with the light emitting unit input terminal 110, of the plurality of terminal-side conductive holes 120.

In some embodiments, at least one light emitting unit input terminal 110 of a plurality of light emitting unit input terminals 110 may cover at least one terminal-side conductive hole 120 of a plurality of terminal-side conductive holes 120, for example, at least one light emitting unit input terminal 110 of the plurality of light emitting unit input terminals 110 may partially or wholly cover at least one terminal-side conductive hole 120, which is electrically connected with the light emitting unit input terminal 110, of the plurality of terminal-side conductive holes 120. Optionally, at least one light emitting unit input terminal 110 of the plurality of light emitting unit input terminals 110 may not cover at least one terminal-side conductive hole 120, which is electrically connected with the light emitting unit input terminal 110, of the plurality of terminal-side conductive holes 120. Optionally, whether the light emitting unit input terminal 110 covers the terminal-side conductive hole 120 or whether the light emitting unit input terminal 110 partially or wholly covers the terminal-side conductive hole 120 is insignificant, as long as the electrical connection between the light emitting unit input terminals 110 and the terminal-side conductive holes 120 is capable of being effectively implemented to effectively arrange the plurality of light emitting unit input terminals 110 for leading wires from light emitting units 150.

In some embodiments, part of terminals or all of terminals of a plurality of light emitting unit input terminals 110 may be arranged at equal intervals. Optionally, there may be a distance variation range between part or all of light emitting unit input terminals 110 in the plurality of light emitting unit input terminals 110, so that positions of part or all of light emitting unit input terminals 110 in the plurality of light emitting unit input terminals 110 are capable of being flexibly set according to the distance variation range; for example, part of light emitting unit input terminals 110 of the plurality of light emitting unit input terminals 110 may be arranged at equal intervals, and other light emitting unit input terminals 110 may be arranged at unequal intervals, or all of light emitting unit input terminals 110 of the plurality of light emitting unit input terminals 110 may be arranged at unequal intervals.

In some embodiments, part or all of a plurality of light emitting unit input terminals 110 may be arranged in array. Optionally, all of the plurality of light emitting unit input terminals 110 may be arranged in array.

In some embodiments, whether part or all of a plurality of light emitting unit input terminals 110 are arranged in array, an array arrangement mode of the plurality of light emitting unit input terminals 110 may be a matrix, such as a row-and-column mode. In some embodiments, an array arrangement mode of a plurality of light emitting unit input terminals 110 may be different from the row-and-column mode, but may be arrangement modes in other array shapes, such as circular, elliptical, triangular and other array arrangement modes. Optionally, the array arrangement mode of the plurality of light emitting unit input terminals 110 is insignificant, as long as a plurality of light emitting unit input terminals 110 for leading wires from light emitting units 150 are capable of being effectively arranged.

In some embodiments, shapes of part or all of light emitting unit input terminals 110 in a plurality of light emitting unit input terminals 110 may be the same or different. Optionally, since thicknesses of the light emitting unit input terminals 110 are usually very small, the shapes of the light emitting unit input terminals 110 may refer to shapes of surfaces of the light emitting unit input terminals 110. Optionally, the shape of at least one light emitting unit input terminal 110 of the plurality of light emitting unit input terminals 110 may be rectangular, circular, spherical or other shapes, and may also be set to polygonal, irregular or other shapes according to actual conditions such as process requirements.

Referring to Fig. 26, embodiments of the present disclosure provide a display device 300, including the light emitting module 100.

In some embodiments, a display device 300 may be a display module, a display screen, a display or the like. Optionally, the display may include the display screen, and the display screen may include the display module.

In some embodiments, a display device 300 may further include other components for supporting normal operation of the display device 300, such as at least one of a communication interface, a framework, a control circuit and the like.

In some embodiments, whether a display device 300 is a display module, a display screen or a display, the display device 300 may perform 2D display, and may also perform 3D display.

In some embodiments, different display devices 300 may be spliced together. Optionally, a mode of splicing different display devices 300 together and the number of spliced display devices 300 may be considered according to actual conditions such as process requirements. Optionally, there may be no lining frame between two spliced display devices 300.

In some embodiments, part or all of a plurality of display devices 300 spliced together may be arranged in array. In some embodiments, an array arrangement mode of the plurality of display devices 300 may be a matrix, such as a row-and-column mode. In some embodiments, an array arrangement mode of a plurality of display devices 300 may be different from the row-and-column mode, but may be arrangement modes in other array shapes, such as circular, elliptical, triangular and other array arrangement modes.

By the light emitting module and the display device provided by embodiments of the present disclosure, terminals for leading wires from light emitting devices may also be effectively arranged, and the light emitting devices may be accordingly controlled even if a size of the light emitting devices is very small.

The above description and drawings sufficiently illustrate the embodiments of the present disclosure to enable those skilled in the art to practice them. Other embodiments may include structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "include" and its variations "includes" and/or "including", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "includes a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

Those skilled in the art may recognize that the units and algorithm steps of each example described in conjunction with the embodiments disclosed herein can be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

In the accompanying drawings, width, length, thickness and the like of structures such as elements or layers may be exaggerated for clarity and description. When a structure such as an element or layer is referred to as being "arranged" (or "mounted", "laid", "attached", "coated" and the like) "above" or "on" another element or layer, the structure such as the element or layer may be directly "arranged" "above" or "on" another element or layer, or a structure such as an intermediate element or layer exists between the element or layer and the another element or layer and even is partially embedded in the another element or layer.

## Claims

1. A light emitting module, comprising: a light emitting structure, an intermediate substrate, an Integrated Circuit, IC, and an IC input structure; wherein
the IC input structure is configured to transmit an IC driving input for driving the IC to the IC;
the IC comprises an IC main body and a plurality of IC output terminals; wherein
the plurality of IC output terminals are configured to transmit light emitting unit driving inputs for driving the light emitting structure;
the intermediate substrate is electrically connected between the light emitting structure and the IC, and is configured to transmit the light emitting unit driving inputs from the IC to the light emitting structure;
the light emitting structure comprises: a light emitting structure electrical connection layer, a light emitting unit layer and a plurality of light emitting unit input terminals; wherein
the light emitting unit layer comprises a plurality of light emitting units;
the light emitting structure electrical connection layer is formed at the light emitting unit layer through a semiconductor process, and is configured to electrically connect the plurality of light emitting unit input terminals with the plurality of light emitting units;
the plurality of light emitting unit input terminals are configured to receive the light emitting unit driving inputs.

2. The light emitting module according to claim 1, wherein the intermediate substrate comprises: a substrate electrical connection layer, a plurality of substrate input terminals and a plurality of substrate output terminals; wherein
the substrate electrical connection layer is configured to electrically connect the plurality of substrate input terminals with the plurality of substrate output terminals;
the plurality of substrate input terminals are configured to receive the light emitting unit driving inputs from the IC;
the plurality of substrate output terminals are configured to transmit the light emitting unit driving inputs to the plurality of light emitting unit input terminals.

3. The light emitting module according to claim 2, wherein the plurality of substrate output terminals are electrically connected with the plurality of light emitting unit input terminals.

4. The light emitting module according to claim 3, wherein different substrate output terminals of the plurality of substrate output terminals are electrically connected with different light emitting unit input terminals of the plurality of light emitting unit input terminals, respectively.

5. The light emitting module according to claim 4, wherein the plurality of substrate output terminals are arranged opposite to the plurality of light emitting unit input terminals.

6. The light emitting module according to claim 5, wherein the plurality of substrate output terminals and the plurality of light emitting unit input terminals are arranged in a package body.

7. The light emitting module according to claim 2, wherein the plurality of substrate input terminals are electrically connected with the plurality of substrate output terminals through substrate connecting paths.

8. The light emitting module according to claim 2, wherein the plurality of IC output terminals are electrically connected with the plurality of substrate input terminals.

9. The light emitting module according to claim 8, wherein different IC output terminals of the plurality of IC output terminals are electrically connected with different substrate input terminals of the plurality of substrate input terminals, respectively.

10. The light emitting module according to claim 9, wherein the plurality of IC output terminals are arranged opposite to the plurality of substrate input terminals.

11. The light emitting module according to claim 10, wherein the plurality of IC output terminals and the plurality of substrate input terminals are arranged in a package body.

12. The light emitting module according to any one of claims 1-11, wherein the IC input structure comprises: a plurality of IC input terminals, arranged at the IC main body and configured to transmit the IC driving inputs to the IC main body.

13. The light emitting module according to claim 12, wherein the plurality of IC input terminals are arranged at one side, away from the light emitting structure, of the IC main body.

14. The light emitting module according to claim 12, wherein the IC input structure further comprises: a plurality of IC input connecting terminals, arranged at the intermediate substrate, electrically connected with the plurality of IC input terminals and configured to transmit the IC driving inputs to the IC input terminals.

15. The light emitting module according to claim 14, wherein different IC input terminals of the plurality of IC input terminals are electrically connected with different IC input connecting terminals of the plurality of IC input connecting terminals, respectively.

16. The light emitting module according to claim 15, wherein the plurality of IC input terminals are arranged opposite to the plurality of IC input connecting terminals.

17. The light emitting module according to claim 16, wherein the plurality of IC input terminals and the plurality of IC input connecting terminals are arranged in a package body.

18. The light emitting module according to any one of claims 14-17, wherein the IC input structure further comprises: a plurality of connector receiving terminals, arranged at the intermediate substrate, electrically connected with the plurality of IC input connecting terminals, and configured to receive IC driving inputs to be transmitted by the plurality of IC input connecting terminals and transmit the IC driving inputs to the plurality of IC input connecting terminals.

19. The light emitting module according to claim 18, further comprising: a connector, electrically connected with the plurality of connector receiving terminals and configured to transmit the IC driving inputs to the plurality of connector receiving terminals.

20. The light emitting module according to claim 18, wherein the plurality of IC input connecting terminals are electrically connected with the plurality of connector receiving terminals through IC input connecting paths.

21. The light emitting module according to claim 1, wherein the IC main body comprises an IC die.

22. The light emitting module according to claim 21, wherein the IC die is arranged in a package body.

23. The light emitting module according to claim 1, wherein the intermediate substrate is a Printed Circuit Board, PCB.

24. The light emitting module according to claim 1, wherein from the light emitting unit layer to the plurality of light emitting unit input terminals, the light emitting unit layer, the light emitting structure electrical connection layer and the plurality of light emitting unit input terminals are sequentially arranged.

25. The light emitting module according to claim 1, wherein in part or all of the plurality of light emitting units, a light emitting unit light isolation structure is arranged between two adjacent light emitting units.

26. The light emitting module according to claim 1, further comprising: a light conversion layer, comprising a plurality of pixel units.

27. The light emitting module according to claim 26, wherein the light conversion layer is arranged at one side, away from the light emitting structure electrical connection layer, of the light emitting unit layer.

28. The light emitting module according to claim 26, wherein in part or all of the plurality of pixel units, a pixel light isolation structure is arranged between two adjacent pixel units.

29. The light emitting module according to claim 26, further comprising: a light-transmissive substrate.

30. The light emitting module according to claim 29, wherein in a case that the light conversion layer is arranged at one side, away from the light emitting structure electrical connection layer, of the light emitting unit layer, the light-transmissive substrate is arranged at one side, away from the light emitting unit layer, of the light conversion layer.

31. The light emitting module according to claim 1, wherein the plurality of light emitting units comprise at least one Light Emitting Diode, LED.

32. The light emitting module according to claim 31, wherein the at least one LED comprises at least one of:
at least one Mini LED;
at least one Micro LED.

33. The light emitting module according to any one of claims 1-32, wherein the light emitting structure electrical connection layer comprises: a plurality of terminal-side conductive holes and a plurality of light emitting unit-side conductive holes; wherein
the light emitting structure electrical connection layer is electrically connected with a plurality of light emitting units through the plurality of light emitting unit-side conductive holes, and is electrically connected with the plurality of light emitting unit input terminals through the plurality of terminal-side conductive holes.

34. The light emitting module according to claim 33, wherein the light emitting structure electrical connection layer at least comprises a light emitting unit-side electrical connection layer and a terminal-side electrical connection layer; the plurality of light emitting unit-side conductive holes comprise a plurality of first light emitting unit conductive holes and a plurality of second light emitting unit conductive holes;
wherein the light emitting unit-side electrical connection layer is electrically connected with the plurality of light emitting units through the plurality of first light emitting unit conductive holes;
the terminal-side electrical connection layer is electrically connected with the plurality of light emitting units through the plurality of second light emitting unit conductive holes.

35. The light emitting module according to claim 34, wherein at least one of the plurality of light emitting units comprises a first electrode and a second electrode;
wherein the light emitting unit-side electrical connection layer is electrically connected with the first electrode through at least one of the plurality of first light emitting unit conductive holes;
the terminal-side electrical connection layer is electrically connected with the second electrode through at least one of the plurality of second light emitting unit conductive holes.

36. The light emitting module according to claim 34 or 35, wherein the plurality of terminal-side conductive holes comprise a plurality of first terminal conductive holes and a plurality of second terminal conductive holes;
wherein the light emitting unit-side electrical connection layer is electrically connected with the plurality of light emitting unit input terminals through the plurality of first terminal conductive holes;
the terminal-side electrical connection layer is electrically connected with the plurality of light emitting unit input terminals through the plurality of second terminal conductive holes.

37. The light emitting module according to claim 36, wherein the plurality of light emitting unit input terminals comprise at least one first light emitting unit input terminal and at least one second light emitting unit input terminal;
wherein the light emitting unit-side electrical connection layer is electrically connected with the at least one first light emitting unit input terminal through at least one of the plurality of first terminal conductive holes;
the terminal-side electrical connection layer is electrically connected with the at least one second light emitting unit input terminal through at least one of the plurality of second terminal conductive holes.

38. The light emitting module according to any one of claims 34-37, wherein at least one of the light emitting unit-side electrical connection layer and the terminal-side electrical connection layer is arranged in the following modes:
the light emitting unit-side electrical connection layer comprises at least one layer of light emitting unit-side conductive lines;
the terminal-side electrical connection layer comprises at least one layer of terminal-side conductive lines.

39. The light emitting module according to claim 38, wherein
each line of the terminal-side conductive lines is electrically connected with at least one light emitting unit input terminal of the plurality of light emitting unit input terminals, or
each line of the light emitting unit-side conductive lines is electrically connected with at least one light emitting unit input terminal of the plurality of light emitting unit input terminals.

40. A display device, comprising the light emitting module of any one of claims 1-39.
